# FASCICULE DE BREVET EUROPEEN

(11) **EP 3 550 605 B1**
(45) Date de publication et mention de la délivrance du brevet: **04.11.2020**
(21) Numéro de dépôt: 19166649.4
(22) Date de dépôt: 01.04.2019
(51) Int. Cl.: H01L 27/144, H01L 31/0296, H01L 27/146

(54) **SUPPORT POUR LA FORMATION D'UN COMPOSANT OPTOÉLECTRONIQUE, COMPOSANT OPTOÉLECTRONIQUE ET PROCÉDÉ DE FABRICATION D'UN TEL SUPPORT ET D'UN TEL COMPOSANT**
TRÄGER FÜR DIE HERSTELLUNG EINER OPTOELEKTRONISCHEN KOMPONENTE, OPTOELEKTRONISCHE KOMPONENTE, HERSTELLUNGSVERFAHREN EINES SOLCHEN TRÄGERS UND EINER SOLCHEN KOMPONENTE
SUPPORT FOR FORMING AN OPTOELECTRONIC COMPONENT, OPTOELECTRONIC COMPONENT AND METHOD FOR MANUFACTURING SUCH A SUPPORT AND SUCH A COMPONENT

(30) Priorité: 03.04.2018 FR 1800273
(43) Date de publication de la demande: 09.10.2019
(73) Titulaire: Commissariat à l'énergie atomique et aux énergies alternatives, 75015 Paris (FR)
(72) Inventeur: BOULARD, François, 38054 GRENOBLE CEDEX 09 (FR); GRANGIER, Christophe, 38054 GRENOBLE CEDEX 09 (FR)
(74) Mandataire: Brevalex

(56) Documents cités:
- US-A- 5 177 580
- US-A1- 2015 243 825
- US-A1- 2016 064 335

## Description

### DOMAINE TECHNIQUE

L'invention concerne le domaine de la microélectronique et de l'optoélectronique et vise plus particulièrement la détection de rayonnements infrarouges.

L'invention a plus particulièrement pour objet un premier support destiné à la formation d'un composant optoélectronique, ledit composant optoélectronique et les procédés de fabrication dudit premier support et dudit composant.

### ÉTAT DE LA TECHNIQUE ANTÉRIEURE

La fabrication de composants optoélectroniques, tels qu'un détecteur matriciel, requière souvent l'assemblage de plusieurs supports entre eux.

En effet, si l'on prend l'exemple ci-dessus du capteur matriciel, un tel composant comporte :
- un premier support comprenant les structures de captation en tant que telle, par exemple des structures du type diode (plus précisément photodiode)
- un deuxième support comprenant des éléments optiques, tels que des lentilles et/ou des filtres en longueurs d'onde,
- un troisième support comprenant un circuit de commande et de traitement adapté pour alimenter les structures et traiter les signaux générés par ces dernières lors de la réception d'un rayonnement par ces dernières.

Dans une configuration usuelle d'un tel composant :
- le premier support présente une première et une deuxième face et comprend une pluralité de structures, affleurant la première face et présentant chacune au moins un contact métallique,
- le deuxième support comprend la pluralité d'éléments optiques, en correspondance chacun à une structure respective du premier support, le deuxième support étant assemblé au premier support par la deuxième face dudit premier support avec chacun des éléments optiques aligné avec la structure correspondante,
- le troisième support comprend une pluralité de structures de traitement et une pluralité de contacts métalliques correspondant chacun à un contact métallique du premier support, le troisième support étant assemblé au premier support pas la première face dudit premier support avec chacun des contacts métalliques du troisième support aligné et mis en contact par hybridation par bille d'indium avec un contact métallique correspondant du troisième support.

Ainsi la fabrication d'un tel composant passe nécessairement par des étapes d'alignement des deuxième et troisième supports vis-à-vis du premier support et de ses structures. Si l'alignement du troisième support vis-à-vis du premier support est rendu relativement aisé de par la présence des contacts métalliques sur la première face du premier support, l'étape d'alignement du deuxième support vis-à-vis du premier support est particulièrement problématique. Celle- ci doit, en effet, se faire relativement aux structures se trouvant à l'opposé de la deuxième face du premier support à laquelle le deuxième support doit être assemblé.

Afin de faciliter un tel alignement du deuxième support vis-à-vis du premier support, il est connu des documents US 5075201 et FR 3025359 de prévoir sur le premier support des zones de marquage.

Dans le cas du document US 5075201, ces zones de support traversent de part en part le premier support et sont donc disponibles sur chacune de la première et la deuxième face du support. Dans le cas du document FR 3025359, ces zones de marquage sont obtenues par le ménagement de creux sur un substrat de croissance et par la croissance d'une couche semiconductrice, destinée à former le premier support, sur ledit substrat. Après suppression du substrat par une gravure sélective, le report des creux du substrat de croissance permet de créer des zones de marquage sur chacune de la première et la deuxième face, les unes positives, c'est-à-dire sous la forme de saillies, et les autres négatives, c'est-à-dire sous la forme de creux.

Néanmoins, si ces zones de marquage, qu'elles soient conformes au document US 5075201 ou au document FR 3025359, permettent un alignement du deuxième support vis-à-vis du premier support, elles ne sont aucunement corrélées au réel positionnement des structures du premier support. L'enseignement de ces deux documents ne permet donc pas de tenir compte d'un éventuel désalignement entre les zones de marquage et les structures du type diode du premier support et peut donc être préjudiciable à la fabrication du composant et donc engendrer un disfonctionnement du composant obtenu.

On notera qu'il est également connu des documents US 5177580 A et du document US 2015/243825 A1 des supports et des procédé de modelage de support utilisés pour la fabrication de photodétecteurs.

On notera en particulier que le document US 5177580 divulgue un support présentant une première et une deuxième face et comprenant trois couches semiconductrices présentant ensemble une première et une deuxième surface formant respectivement la première et la deuxième face du support, chacune des couches semiconductrices étant réalisée dans un matériau respectif comprenant du cadmium. Les couches semiconductrices comprennent une pluralité de structures du type diode dont au moins un contact métallique affleure de la première surface, chacune des structures comportant une portion formée par l'une des couches semiconductrices formant une zone dopée respective en un emplacement de ladite couche semiconductrice. Chacune des zones présente un deuxième type de conductivité dans lequel les trous sont les porteurs majoritaires, ledit deuxième type de conductivité étant fourni au moyen d'un dopage arsenic de ladite couche semiconductrice formant lesdites zones. Le support comprend en outre une ouverte aménagée dans la couche semiconductrice, formant les zones dopées et comprenant la première surface, et en partie dans la couche semiconductrice qui est directement en contact avec ladite couche semiconductrice formant les zones dopées.

Ce support décrit dans le document US 5177580 présente l'avantage d'être réalisé sans nécessiter de marque de masquage, puisque le procédé permettant sa formation est auto-aligné. Néanmoins, de ce fait, ce support n'est pas particulièrement adapté pour autoriser la connexion des diodes qu'il comporte avec le circuit d'un quelconque deuxième support puisque ce support ne comporte pas de marque de marquage en tant que telle.

### EXPOSÉ DE L'INVENTION

L'invention vise à remédier à cet inconvénient et a ainsi pour but de fournir un premier support qui présente des zones de marquage parfaitement corrélées au positionnement des structures du type diode dudit premier support.

L'invention a ainsi pour objet un procédé de fabrication d'un premier support destiné à former, avec notamment un deuxième support, un composant optoélectronique, le premier support présentant une première et une deuxième face et comprenant une pluralité de structures du type diode dont au moins un contact métallique affleure de la première surface, et une marque d'alignement sur la deuxième face apte à permettre un alignement avec le deuxième support lors de l'assemblage du premier support par sa deuxième face au deuxième support pour la formation du composant optoélectronique,

Le procédé comprenant les étapes suivantes de :
- fourniture d'un substrat, le substrat comprenant une couche support réalisée dans un premier matériau comprenant du cadmium, et une couche semiconductrice présentant une première et une deuxième surface et étant en contact avec la couche support par la deuxième surface de ladite couche semiconductrice, la couche semiconductrice étant réalisée dans un deuxième matériau comprenant une proportion atomique en cadmium x₂ plus faible à une proportion atomique en cadmium x₁ du premier matériau,
- formation d'une ouverture dans la couche semiconductrice à partir de la première surface en direction de la deuxième surface,
- implantation localisée d'arsenic de la couche semiconductrice au travers de la première surface sur une pluralité de premiers emplacements de la couche semiconductrice et en un deuxième emplacement situé dans l'ouverture destinés à la formation de respectivement les structures et une marque d'alignement, l'implantation localisée atteignant la deuxième surface dans le deuxième emplacement,
- traitement thermique apte à activer l'arsenic implanté sur la pluralité de premiers emplacements pour former des zones dopées d'un deuxième type de conductivité dans lequel les porteurs majoritaires sont des trous, lesdites zones dopées participant à la formation des structures, le traitement thermique étant également adapté pour permettre une diffusion du cadmium de la couche support vers le deuxième emplacement, ladite diffusion étant favorisée par l'arsenic implanté dans ledit deuxième emplacement et permettant la fourniture de la marque d'alignement affleurant la deuxième surface et qui présente une proportion atomique en cadmium x₃ moyenne supérieure à la proportion atomique en cadmium x₂ moyenne du reste de la couche semiconductrice à la même distance de la deuxième surface,
- suppression de la couche de support et d'une partie de l'épaisseur de la couche semiconductrice au moyen d'une gravure sensible à la proportion atomique en cadmium ceci de manière à ce que la deuxième surface de la couche semiconductrice présente une différence de hauteur entre la marque d'alignement , qui affleure la deuxième surface et qui correspond au deuxième emplacement, et le reste de la deuxième surface, la couche semiconductrice ainsi libérée de la couche support formant le premier support, la première et la deuxième surface de la couche semiconductrice formant les première et deuxième faces dudit premier support.

Ainsi, avec un tel procédé, la marque d'alignement est positionnée sur le deuxième emplacement qui est lui-même défini par l'implantation d'arsenic pendant la formation des zones dopées des structures du premier support. Il en résulte que le positionnement de la marque d'alignement sur la deuxième face du support est directement lié à celui des zones de dopages des structures disposées sur la première face du premier support.

Avec un premier support obtenu par un procédé selon l'invention, il est donc ainsi aisé d'utiliser la marque d'alignement lors de l'assemblage avec un deuxième support pour assurer un bon alignement entre les éléments optiques du deuxième support et les structures du premier support.

On entend ci-dessus et dans le reste de ce document par gravure sensible à la proportion en cadmium, un procédé de gravure qui présente une vitesse de gravure variant en fonction de la proportion en cadmium. On notera qu'un tel procédé de gravure sensible à la proportion en cadmium comprend, dans le cadre de l'invention, aussi bien ceux présentant une vitesse de gravure qui augmente lorsque la proportion en cadmium augmente que ceux présentant une vitesse de gravure qui diminue lorsque la proportion en cadmium augmente.

On entend ci-dessus et dans le reste de ce document par proportion atomique de cadmium d'un matériau comprenant du cadmium, la proportion x d'atome de cadmium parmi le ou les éléments de la colonne II du tableau périodique composant ledit matériau, un tel matériau étant généralement composé d'élément de la colonne II et d'élément de la colonne VI du tableau périodique. Ainsi, si l'on prend l'exemple des tellurures de mercure cadmium CdₓHg₁₋ₓTe, x correspond à la proportion atomique en cadmium.

On peut noter, qu'en alternative de la proportion atomique en cadmium, il est possible d'utiliser la fraction atomique en cadmium. En effet, les matériaux contenant du cadmium comporte, pour être stable, autant d'éléments de la colonne II du tableau périodique que d'élément de la colonne VI du tableau périodique. Ainsi une proportion atomique de cadmium x donnée correspondra à une fraction atomique x/2. Un matériau présentant une proportion atomique en cadmium supérieure à celle d'un autre matériau présente donc également une fraction atomique en cadmium supérieure à celle de ce même autre matériau. Ainsi toutes les inégalités mentionnant la proportion atomique en cadmium sont également valables en ce qui concerne la fraction atomique en cadmium, c'est deux types d'inégalité étant donc parfaitement interchangeable.

Le deuxième support peut être fonctionnalisé et ainsi comporter des éléments, en tant que fonctionnalité, correspondant chacun à une structure respective du premier support de sorte que quand le deuxième support est assemblé au premier support en étant aligné à ce dernier au moyen de la marque d'alignement, chacune des structures est alignée à l'élément correspondant.

Le premier matériau peut comprendre au moins un premier élément de la colonne VI du tableau périodique et au moins un deuxième élément de la colonne II du tableau périodique dont le cadmium, le cadmium présentant une proportion atomique x₁ du ou desdits deuxièmes éléments de la colonne II du premier matériau supérieure à 80% et préférentiellement supérieure à 90% voire à 95%.

Un tel premier matériau permet une diffusion efficace de la couche support vers la marque d'alignement assurant une différence de proportion atomique en cadmium importante entre la marque d'alignement et le reste de la couche semiconductrice.

Le deuxième matériau peut comprendre au moins un troisième élément de la colonne VI du tableau périodique et au moins deux quatrièmes éléments de la colonne Il du tableau périodique, l'un des quatrièmes éléments étant le cadmium, le ou les troisièmes éléments pouvant être identiques, distincts ou partiellement distincts du ou des premier éléments, et le ou les quatrièmes éléments, outre le cadmium qui est commun, pouvant être identiques, distincts ou partiellement distincts du ou des deuxièmes éléments.

Le deuxième matériau peut présenter une proportion atomique en cadmium x₂ desdits quatrième éléments de la colonne VI du deuxième matériau inférieure d'au moins 20%, préférentiellement 30%, voire 40%, à la proportion atomique du cadmium x₁ du ou desdits deuxièmes éléments.

Une telle différence de proportion de cadmium favorise la diffusion de cadmium entre la marque d'alignement et le reste de la couche semiconductrice.

Le premier matériau peut être sélectionné dans le groupe comportant du tellurure de cadmium, des tellurures de cadmium et zinc du type Cdₓ₁Zn₁₋ₓ₁Te, les séléniures-tellurures de cadmium du type CdTeₓSe₁₋ₓ, et leurs alliages,

le deuxième matériau pouvant être un tellurure de mercure-cadmium du type Cdₓ₂Hg₁₋ₓ₂Te.

L'invention est particulièrement bénéfique pour de tels premier et deuxième matériaux.

Lors de l'étape formation d'une ouverture, une épaisseur restante D1 de la couche semiconductrice au niveau de l'ouverture peut être comprise entre 0,1 et 2 µm, préférentiellement entre 0,2 et 1 µm, voire 0,4 et 0,8 µm et peut être, par exemple, égale à 0,5 µm.

L'étape implantation localisée d'arsenic de la couche semiconductrice peut comprendre les sous-étapes suivantes :
- première implantation localisée de la couche semiconductrice sur les premiers emplacements et le deuxième emplacement,
- deuxième implantation complémentaire de la couche semiconductrice uniquement sur le deuxième emplacement.

Avec une telle implantation en deux sous-étapes il est possible de décorréler la concentration en porteurs majoritaires des zones dopées et la concentration en arsenic de la marque d'alignement.

Lors de l'étape de suppression de la couche de support et d'une partie de l'épaisseur de la couche semiconductrice, la gravure sélective peut être une gravure plasma hydrocarboné de manière à fournir une marque d'alignement faisant saillie du reste de la deuxième surface de la couche semiconductrice, le plasma utilisé pour la gravure étant préférentiellement à base de méthane et de dihydrogène.

Lors de l'étape de suppression de la couche de support et d'une partie de l'épaisseur de la couche semiconductrice, la gravure peut être une gravure chimique en voie humide à partir d'une solution acide comprenant un oxyde de chrome de manière à fournir une marque d'alignement sous la forme d'un creux vis-à-vis du reste de la deuxième surface de la couche semiconductrice.

L'invention concerne en outre un procédé de fabrication d'un composant optoélectronique comprenant les étapes suivantes :
- fourniture d'un premier support par la mise en œuvre d'un procédé de fabrication d'un premier support selon l'invention,
- fourniture d'un deuxième support,
- assemblage du premier et du deuxième support, le deuxième support étant aligné au premier support au moyen de la marque d'alignement.

Un tel procédé permet de fournir un composant optoélectronique présentant un bon alignement entre le premier et le deuxième support ceci de par la fourniture d'un premier support selon l'invention.

Il peut en outre être prévu lors de la mise en œuvre du procédé de fabrication d'un premier support une étape de formation sur la première surface de la couche semiconductrice des premiers contacts métalliques de chacune des structures,

Le procédé de fabrication d'un composant optoélectronique comportant, que ce soit en tant que tel ou lors de la mise en œuvre du procédé de fabrication d'un premier support, les étapes suivantes :
- fourniture d'un troisième support comportant un circuit électronique de commande et de traitement et des deuxièmes contacts métalliques en correspondance avec les premiers contacts métalliques,
- assemblage du premier et du troisième support par une opération de soudage ou de brasage des premiers contacts sur les deuxièmes contacts, l'assemblage du premier et du troisième support se faisant préférentiellement par hybridation par billes d'indium.

Le deuxième support peut comporter des éléments fonctionnels correspondant chacun à une structure respective du premier support, les éléments fonctionnels étant sélectionnés parmi les éléments optiques dont font partis les filtres en longueurs d'onde et les systèmes de concentration optique, et les éléments de connexion, tels que des pistes de connexion, et dans lequel lors de l'assemblage du premier et du deuxième support, l'alignement du deuxième support au moyen de la marque d'alignement permet d'aligner chaque élément à la structure correspondante.

De telles fonctionnalités bénéficient particulièrement de l'alignement amélioré obtenu par la mise en œuvre du procédé selon l'invention.

L'invention concerne en outre un premier support destiné à former, avec notamment un deuxième support fonctionnalisé, un composant optoélectronique, le premier support présentant une première et une deuxième face et comprenant une couche semiconductrice formant ledit premier support, la couche semiconductrice présentant une première et une deuxième surface formant respectivement la première et la deuxième face du premier support, la couche semiconductrice étant réalisée dans un deuxième matériau qui, comprend une proportion en cadmium x₂,
dans lequel la couche semiconductrice comprend :
- une pluralité de structures du type diode dont au moins un contact métallique affleure de la première surface, les structures comportant des zones dopées chacune en un premier emplacement respectif de la couche semiconductrice, chaque zone dopée présentant un deuxième type de conductivité dans lequel les trous sont les porteurs majoritaires, ce deuxième type de conductivité étant fourni au moyen d'un dopage à l'arsenic.

La couche semiconductrice comprend en outre :
- une ouverture aménagée dans la couche semiconductrice à partir de la première surface en direction de la deuxième surface,
- une marque d'alignement formée en un deuxième emplacement situé dans l'ouverture, la marque d'alignement présentant le deuxième type de conductivité, le deuxième type de conductivité étant fourni au moyen d'un dopage à l'arsenic débouchant sur la deuxième surface, et une proportion en cadmium moyenne x₃ supérieure à la proportion en cadmium moyenne x₂ du deuxième matériau à la même distance de la deuxième surface, la marque d'alignement affleurant la deuxième surface de la couche semiconductrice,
et la deuxième surface de la couche semiconductrice présente une différence de hauteur entre la marque d'alignement, qui affleure de deuxième surface et qui correspond au deuxième emplacement, et le reste de la deuxième surface.

Un tel premier support est particulièrement adapté pour fournir un composant optoélectronique avec un alignement optimisé entre ses premier et deuxième supports.

La marque d'alignement peut se présenter sous la forme d'un creux- vis-à-vis du reste de la deuxième surface de la couche semiconductrice.

La marque d'alignement peut être en saillie vis-à-vis du reste de la deuxième surface de la couche semiconductrice.

L'invention concerne en outre composant optoélectronique comprenant :
- un premier support selon l'invention,
- un deuxième support, le deuxième support comportant des fonctionnalisations à aligner les structures du premier support.

Le premier support est assemblé par sa deuxième face au deuxième support avec les structures alignées avec les fonctionnalisations du deuxième support.

Un tel composant optoélectronique présente un alignement optimisé entre ses premier et deuxième supports.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre en vue en coupe d'un composant optoélectronique selon un premier mode de réalisation,
- les figures 2A et 2B illustrent, pour la figure 2A une vue en coupe d'un substrat assemblé à un troisième support après une étape de recuit thermique mis en œuvre dans le cadre d'un procédé de fabrication d'un composant optoélectronique selon le premier mode de réalisation de l'invention, et pour la figure 2B la variation de la proportion en cadmium le long de l'épaisseur du substrat pour un premier et deuxième plan de coupe montrés sur la figure 2A,
- les figures 3A à 4E illustrent les principales étapes de fabrication d'un premier support d'un composant optoélectronique illustré sur la figure 1,
- les figures 4A et 4B illustrent deux exemples de forme de marque d'alignement envisageables dans le cadre de l'invention,
- la figure 5A et 5B illustrent, respectivement et par une vue en coupe, un premier support et un composant optoélectronique selon un deuxième mode de réalisation dans lequel une marque d'alignement est présente sur une deuxième face du premier support sous la forme d'un creux aménagée dans ladite deuxième face,
- la figure 6 illustre un composant optoélectronique selon un troisième mode de réalisation dans lequel la couche semiconductrice est dopée P, les zones dopées étant agencées pour isolées les structures les unes des autres.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

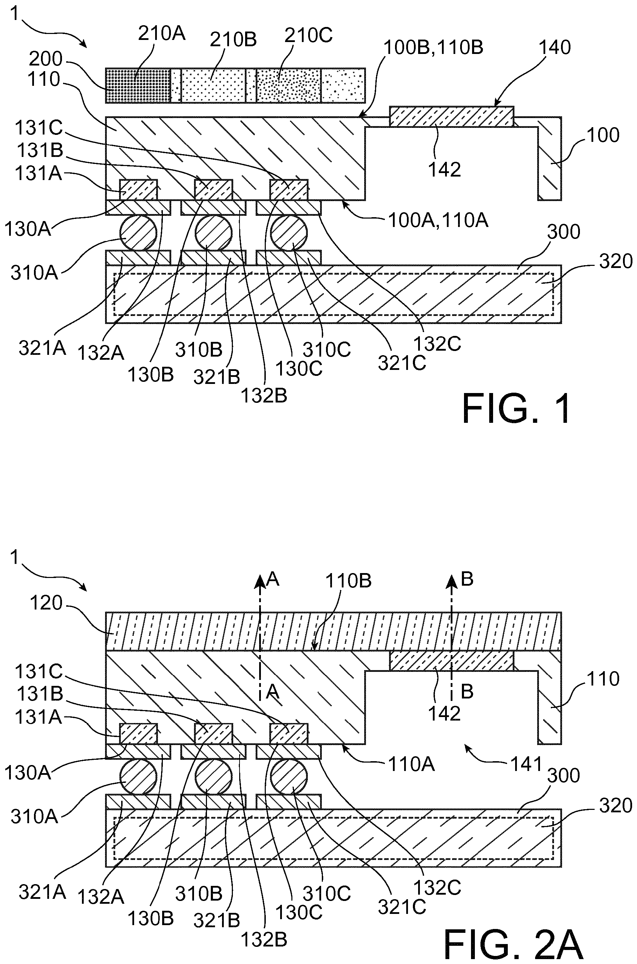

La figure 1 illustre un composant optoélectronique 1 selon un premier mode de réalisation de l'invention présentant un alignement optimisé entre un premier support 100 comprenant des structures 130A, 130B, 130C du type diode et un deuxième support comprenant des éléments optiques 210A, 210B, 210C.

Le composant optoélectronique 1 selon l'invention est plus particulièrement dédiée à la détection de rayonnements électromagnétique dont la longueur d'onde est comprise dans une première gamme de longueurs d'onde de la gamme des infrarouges. On notera que la gamme des infrarouges est classiquement divisée en trois sous-domaines que sont la gamme du proche infrarouge comprise entre 1 et 3 µm, la gamme de l'infrarouge moyen comprise entre 3 et 5 µm et la gamme de l'infrarouge lointain correspondant aux longueurs d'onde comprises entre 8 et 14 µm.

Ainsi, si le composant optoélectronique 1 selon l'invention est particulièrement adapté pour la détection de bandes de longueurs comprises dans la gamme des infrarouges quelles qu'elles soient, dans une application classique de l'invention, le composant optoélectroniques pouvant être en particulier configurer pour la détection dans une ou plusieurs parmi la gamme du proche infrarouge, la gamme de l'infrarouge moyen et la gamme de l'infrarouge lointain.

Un tel composant optoélectronique 1 comporte :
- un premier support 100 présentant une première et une deuxième face et comprenant une pluralité de structures 130A, 130B, 130C du type diode dont au moins un premier contact métallique 132A, 132B, 132C affleure la première surface 100A et une marque d'alignement 140 sur la deuxième face 100B,
- un deuxième support 200 fonctionnalisé comportant une pluralité de fonctionnalités, telles qu'une pluralité d'éléments optiques 210A, 210B, 210C et assemblé au premier support 100 par la deuxième face 100B de ce dernier,
- un troisième support 300 comprenant un circuit de commande et de traitement 320, non représenté, et une pluralité de deuxièmes contacts métalliques 321A, 321B, 321C, correspondant chacun à un premier contact métallique 132A, 132B, 132C du premier support 100, le troisième support 300 étant assemblé au premier support 100 par la première face dudit premier support 100 avec chacun des premiers contacts métalliques 132A, 132B, 132C du premier support 100 aligné et mis en contact électrique par hybridation par billes d'indiums 310A, 310B, 310C avec le deuxième contact métallique 321A, 321B, 321C correspondant du troisième support 300.

Le premier support 100 comprend une couche semiconductrice 110 présentant une première et une deuxième surface 110A, 110B. Plus précisément, la couche semiconductrice forme le support 100, les première et deuxième surfaces 110A, 110B formant respectivement la première et la deuxième face 100A, 100B.

Le deuxième matériau peut ainsi comprendre au moins un troisième élément de la colonne VI du tableau périodique et au moins deux quatrièmes éléments de la colonne II du tableau périodique, l'un des quatrièmes éléments étant le cadmium. Dans une telle conformation, le deuxième matériau présente une proportion atomique en cadmium x₂ desdits quatrième éléments de la colonne II.

Ainsi le deuxième matériau peut être un tellurure de mercure-cadmium du type Cdₓ₂Hg₁₋ₓ₂Te.

La proportion atomique en cadmium x₂ de la couche semiconductrice 110 est adaptée en fonction de la première gamme de longueur d'onde détectée par le premier composant 1. Ainsi, dans le cas où le deuxième matériau est un tellurure de mercure cadmium, la proportion atomique de cadmium peut être choisie comme suit :
- pour une première gamme de longueurs d'onde dans le proche infrarouge, la proportion atomique en cadmium x₂ est comprise entre 0,35 et 0,6,
- pour une première gamme de longueurs d'onde dans le moyen infrarouge, la proportion atomique en cadmium x₂ est comprise entre 0,28 et 0,35,
- pour une première gamme de longueurs d'onde dans les infrarouges lointains, la proportion atomique en cadmium x₂ est comprise entre 0,18 et 0,26.

Ainsi, dans trois applications pratiques de l'invention, la proportion atomique de cadmium x₂ est fixée à respectivement 0,2, 0,3 et 0,5.

On notera que la composition du deuxième matériau n'est pas forcément constante sur toute l'épaisseur de la couche semiconductrice 110, la proportion atomique de cadmium x₂ pouvant diminuer de la deuxième surface 110B vers la première surface 110A. Une telle variation de la proportion atomique de cadmium peut notamment liée au procédé de fabrication du composant optoélectronique selon l'invention.

En effet, comme le montre la figure 2A, la couche semiconductrice 110 est fournie au moyen d'un substrat 100 comportant ladite couche semiconductrice 110 réalisée dans le deuxième matériau et une couche support 120 en contact avec la couche semiconductrice 110 sur la deuxième surface 110B de ladite couche semiconductrice 110. La couche support 120 est réalisée dans un premier matériau comprenant du cadmium Cd avec une proportion atomique en cadmium Cd x₁ supérieure à la proportion atomique en cadmium Cd x₂ du deuxième matériau.

Ainsi, le premier matériau peut comprendre au moins un premier élément de la colonne VI du tableau périodique et au moins un deuxième élément de la colonne II du tableau périodique dont le cadmium Cd, le premier matériau présentant une proportion atomique en cadmium x₁ desdits deuxième éléments de la colonne II supérieure à 80% et préférentiellement supérieure à 90% voire à 95%.

Le deuxième matériau présente une proportion atomique en cadmium x₂ inférieure d'au moins 20%, préférentiellement 30%, voire 40%, à la proportion atomique en cadmium x₁ du premier matériau. Autrement dit, la proportion atomique en cadmium x₂ du deuxième matériau respect l'inégalité suivante : x₂<x₁-20% avec x₁ la proportion atomique en cadmium du premier matériau. La proportion atomique en cadmium x₂ du deuxième matériau respect préférentielle l'une ou les deux inégalités suivantes : x₂<x₁-30% et x₂<x₁-40% avec x₁ la proportion atomique en cadmium du premier matériau.

Le procédé de fabrication du composant optoélectronique 1 pouvant faire intervenir une étape de traitement thermique, il peut résulter d'une telle étape une diffusion de cadmium Cd de la couche support 120 dans la couche semiconductrice 110 à l'interface entre la couche support 120 et la couche semiconductrice 110.

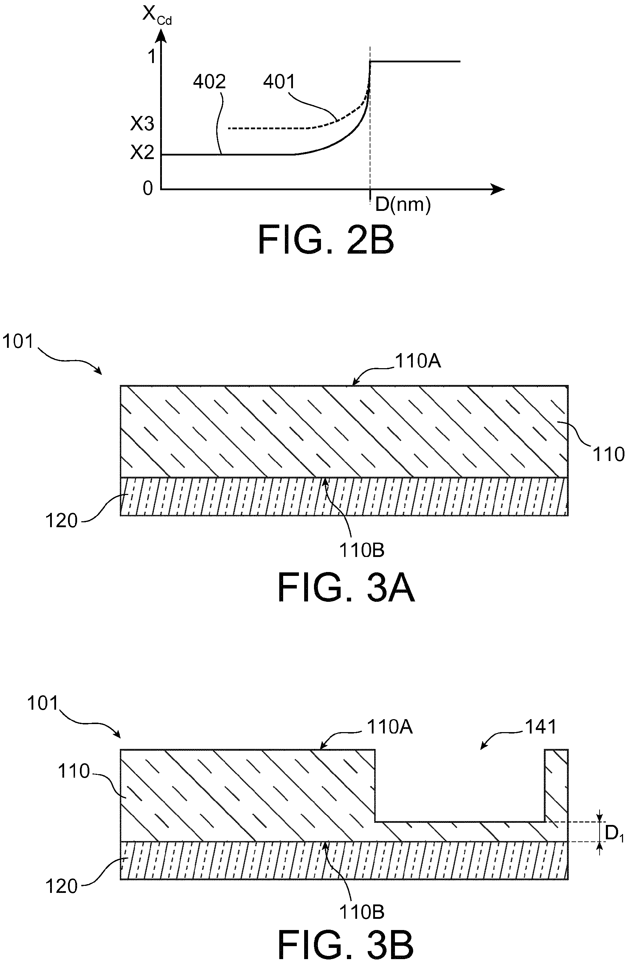

Ainsi comme le montre la figure 2B illustrant en trait plein la variation de la proportion atomique en cadmium x₂ le long de l'épaisseur de la couche semiconductrice 110 selon le plan de coupe AA' de la figure 2A, la proportion atomique de cadmium x₂ de la couche semiconductrice 110 augmente à l'approche de l'interface entre la couche semiconductrice 110 et la couche support pour atteindre, à l'interface entre les premier et deuxième matériaux, la proportion atomique en cadmium x₁ du premier matériau.

On notera que dans un tel substrat 101, le premier matériau est adapté pour la formation par un dépôt par épitaxie de la couche semiconductrice 110 en contact de la couche support 120. Ainsi, le premier matériau peut être sélectionné dans le groupe comportant du tellurure de cadmium CdTe, des tellurures de cadmium et zinc du type Cdₓ₁Zn₁₋ₓ₁Te, les séléniures-tellurures de cadmium du type CdTeₓ₁Se₁₋ₓ₁, et leurs alliages.

Dans ce premier mode de réalisation, le deuxième matériau comporte au moins un élément dopant d'un premier type de conductivité dans lequel les porteurs majoritaires sont des électrons. Autrement dit le deuxième matériau est dopé N. Le deuxième matériau peut présenter une concentration en éléments dopants donneurs d'électrons comprise entre 1.10¹³ et 1.10¹⁷ cm⁻³, voire entre 5.10¹⁴ et 4.10¹⁵ cm⁻³. Ainsi, par exemple, le deuxième matériau peut présenter une concentration en porteur majoritaire sensiblement égale à 1.10¹⁵ cm⁻³.

La couche semiconductrice 110 comporte la pluralité de structures 130A, 130B, 130C du type diode affleurant la première surface 110A et la marque d'alignement.

Chacune des structures 130A, 130B, 130C comprend :
- une zone dopée 131A, 131B, 131C aménagée à partir d'un premier emplacement respectif de la première surface 110A,
- un premier contact métallique 132A, 132B, 132C de la zone dopée 131A, 131B, 131C de ladite structure 130A, 130B, 130C et adapté pour être mis en contact avec un contact métallique correspondant du troisième support 300 par hybridation par bille d'indium.

On notera que la couche semiconductrice 110 comporte en outre un ou plusieurs troisièmes contacts métalliques, non figurés, adaptés pour permettre d'appliquer une polarisation à ladite couche semiconductrice. Ainsi chacune des structures 131A, 131B, 131C peut être polarisée au moyen de son premier contact métallique 132A, 132B, 132C et du troisième contact métallique qui est un contact métallique collectif.

Chacune des zones dopées 131A, 132B, 132C comprend de l'arsenic As en tant qu'élément dopant afin de fournir un dopage d'un deuxième type de conductivité pour lequel les porteurs majoritaires sont des trous. Autrement dit, chacune des zones dopées 131A, 131B, 131C présente un dopage P.

Chacune des zones dopées 131A, 131B, 131C est fournie par une implantation d'arsenic As avec une dose comprise entre 1.10¹³ et 1.10¹⁶ cm⁻². La dose d'implantation peut ainsi être, par exemple, comprise entre 5.10¹⁴ et 5.10¹⁵ cm⁻² et est préférentiellement sensiblement égale à 1.10¹⁵ cm⁻².

Avec une telle dose, la concentration en arsenic As dans les zones dopées peut être comprise entre 2.10¹⁵ et 2.10¹⁸ cm⁻³, voire entre 1.10¹⁷ et 1.10¹⁸ cm⁻³ et préférentiellement sensiblement égale à 2.10¹⁷ cm⁻³.

Selon, une première possibilité de ce premier mode de réalisation, les zones dopées s'étendent à partir du premier emplacement de la première surface sur une épaisseur de la première surface égale à D2.En variante, selon une deuxième possibilité non illustrée de ce premier mode de réalisation, les zones dopées peuvent être au moins partiellement enterrés, les zones dopées étant fournies par une implantation d'arsenic As à distance de la première surface 110A. Selon cette variante, les premiers contacts métalliques, affleurant de la première surface 110A, se prolongent dans la couche semiconductrice 110 de manière à atteindre les zones dopées correspondantes.

La couche semiconductrice 110 comprend en outre une ouverture 141 aménagée à partir de la première surface 110A en direction de la deuxième surface 110B, une épaisseur restante de la couche semiconductrice 110 au niveau de l'ouverture 141 étant inférieure ou égale à une valeur D1 qui est elle-même inférieure ou égale à D2. Autrement dit, l'épaisseur restante au niveau de l'ouverture 141 est inférieure ou égale à D2.

On notera que la valeur D1 peut être comprise entre 0,1 et 2 µm, préférentiellement entre 0,2 et 1 µm, voire 0,4 et 0,8 µm et peut être, par exemple, sensiblement égale à 0,5 µm.

La couche semiconductrice 110 comporte également une marque d'alignement 140 formée en un deuxième emplacement 142 situé dans l'ouverture 141. La marque d'alignement 142 est dopée P, l'élément dopant de ladite zone étant de l'arsenic As. Selon une première possibilité de ce premier mode de réalisation, la dose en arsenic implanté et donc la concentration élément dopant de la marque d'alignement sont sensiblement identique à celle des zones dopées 131A, 131B, 131C.

En variante à ce premier mode de réalisation, l'implantation en arsenic As sur les premiers emplacements et le deuxième emplacement peut être réalisée en plusieurs sous étape, une première sous étape lors de laquelle sont implanté avec une première dose d'arsenic les premiers emplacements et le deuxième emplacement et une deuxième sous étape dans laquelle seule le deuxième emplacement est implanté avec une deuxième dose complémentaire. Ainsi, selon cette variante, les zones dopées 131A, 131B, 131C et la marque d'alignement 140 peuvent présenter une concentration en porteurs majoritaires distincts les unes de l'autre, la marque d'alignement présentant alors une concentration en porteurs majoritaires supérieure à celle des zone dopées 131A, 131B, 131C.

On notera que le deuxième emplacement 142 présente une dimension inférieure à celle de l'ouverture 141.

La marque d'alignement 140 comporte en outre une proportion atomique en cadmium x₃ moyenne supérieure à celle du reste de la couche semiconductrice 110. Cette différence de proportion atomique est obtenue par une diffusion de cadmium Cd de la couche support 120 favorisée par la présence d'arsenic As dans la marque d'alignement 142 lors de l'étape de traitement de thermique.

Les figures 2A et 2B illustrent ce phénomène de diffusion favorisée par l'arsenic As. La figure 2A illustre ainsi le support après l'étape de traitement thermique et montre un premier plan de coupe AA' le long de la couche semiconductrice 110 en dehors du deuxième emplacement 142 et un deuxième plan de coupe BB' le long de la couche semiconductrice 110 interceptant le deuxième emplacement 142. La figure 2B illustre en trait plein et en pointillés la variation de la proportion atomique en cadmium Cd le long de la couche semiconductrice 110 au niveau de respectivement le plan AA' et le plan BB'. On peut ainsi observer que le dopage à l'arsenic As au niveau du deuxième emplacement 142 a permis de favoriser une diffusion du cadmium par rapport au reste de la couche semiconductrice 110, la proportion atomique en cadmium x₃ étant plus importante à profondeur donnée que dans le reste de la couche semiconductrice 110 à cette même profondeur.

Ainsi, la marque d'alignement 140 présente une proportion atomique en cadmium x₃ supérieure à la proportion atomique cadmium x₂ du reste de la couche semiconductrice 110 à la même distance de la deuxième surface 110B.

Pour plus d'information sur ce phénomène utilisé dans le cadre de l'invention concernant la diffusion du cadmium Cd favorisée par la présence d'arsenic As, le lecteur peut se conférer aux travaux de L. Mollard et de ses coauteurs publiés en 2009 dans La revue scientifique « Journal of Electronic Materials » volume 38 numéro 8 pages 1805 à 1813.

D'une telle diffusion, il résulte donc une différence de proportion atomique en cadmium x₃-x₂ entre la marque d'alignement 140 et le reste de la couche semiconductrice 110.

Ainsi on peut prendre, par exemple, les conditions suivantes :
- un premier matériau présente une proportion atomique en cadmium x₁ supérieure à 0,95, par exemple un tellurure de cadmium et zinc du type Cdₓ₁Zn₁₋ₓ₁Te avec une proportion atomique en cadmium x₁ égale à 0,96,
- un deuxième matériau présentant respectivement une proportion atomique en cadmium x₂ respectivement de 0,2, 0,3 et 0,5 à 0,6, par exemple un tellurure de mercure-cadmium du type Cdₓ₂Hg₁₋ₓ₂Te.

Dans ces conditions, en conformité avec les travaux de L. Mollard et ses coauteurs, on peut s'attendre à une proportion atomique en cadmium dans la marque d'alignement 140 de respectivement 0,4, 0,5 et 0,6 à 0,8 pour les valeurs de proportion en cadmium de 0,2, 0,3 et 0,5 à 0,6. Autrement dit, une différence de proportion d'environ 0,2, soit une différence de fraction atomique d'environ 0,1.

Comme illustré sur la figure 1, la deuxième surface 110B de la couche semiconductrice 110 présente une différence de hauteur entre la marque d'alignement 140, qui affleure de deuxième surface 110B et qui correspond au deuxième emplacement 142, et le reste de la deuxième surface 110B. Ainsi, comme le montre la figure 1, dans ce premier mode de réalisation, la marque d'alignement 110 fait saillie du reste de la deuxième surface 110B de la couche semiconductrice 110.

Une telle saillie de la marque d'alignement 140 vis-à-vis du reste de la deuxième surface 110B est obtenue, dans le cadre l'invention, par l'utilisation d'un procédé de gravure sensible à la proportion atomique en cadmium Cd. Plus précisément, le procédé de gravure employé est un procédé de gravure qui présente une vitesse de gravure qui diminue pour une proportion atomique en cadmium qui augmente.

Ainsi, selon ce premier mode de réalisation, le procédé de gravure employé peut être un procédé de gravure plasma hydrocarboné tel qu'un plasma à base de méthane CH₄ et de dihydrogène H₂. En effet, comme l'ont montré les travaux de F. Boulard et ses coautheurs publiés en 2010 dans la revue scientifique « Journal of Electronic Materials » Volume 39 Numéro 8 pages 1256 à 1261, avec un plasma composé de méthane et de dihydrogène, la vitesse de gravure présente une forte dépendance à la composition en cadmium. Ainsi, il a été observé dans le cadre de ces travaux que la vitesse de gravure était :
- de 100 nm.min⁻¹ pour une proportion atomique en cadmium de 0,6,
- de 220 nm.min⁻¹ pour une proportion atomique en cadmium de 0,3,
- de 300 nm.min⁻¹ pour une proportion atomique en cadmium de 0,23.

Sur cette base et si l'on prend comme exemple un deuxième matériau présentant une proportion atomique en cadmium de 0,23 et une marque d'alignement 140 présentant une proportion atomique en cadmium de 0,3, il est possible d'aboutir à une différence de hauteur entre la marque d'alignement 140 et le reste de la première surface 110B de 80 nm après 1min de gravure de l'interface 110B.

Bien entendu, la gravure est configurée pour fournir une gravure partielle du reste de la couche semiconductrice 110 au niveau de l'ouverture. Autrement dit, la gravure est configurée pour fournir une gravure de la couche semiconductrice, que ce soit au niveau du deuxième emplacement ou sur le reste de la deuxième surface, sur une épaisseur inférieure à D1.

De la même façon, selon une préférence de l'invention, la gravure est configurée pour fournir une différence de hauteur entre la marque d'alignement 140 et le reste de la surface qui est comprise entre 10 et 500 nm, voire entre 50 et 300 nm.

Une telle différence de hauteur est parfaitement identifiable avec les outils d'alignement accessibles à l'homme du métier et offre donc la possibilité d'aligné le deuxième support par rapport à la deuxième face 110B premier support 100 et ses structures 130A, 130B, 130C malgré le fait que lesdites structures sont accessibles uniquement sur la première face 100A du premier support.

On notera, de plus qu'un tel procédé de gravure par un plasma à base de méthane CH₄ et de dihydrogène H₂ est particulièrement avantageux puisqu'il présente, en plus d'une vitesse de gravure dépendante de la proportion en cadmium Cd, la génération d'une rugosité également dépendante de cette même proportion. Ainsi, la variation de rugosité liée à la différence de proportion en cadmium entre la marque d'alignement 140 et le reste de la deuxième surface 110

Selon une première possibilité de ce premier mode de réalisation, le deuxième support 200 comprend une pluralité d'éléments optiques 210A, 210B, 210C chacun configuré pour être associé avec une structure 130A, 130B, 130C respective de la couche semiconductrice 100. Ces éléments optiques 210A, 210B, 210C sont adaptés pour intercepter un rayonnement électromagnétique arrivant en direction du deuxième support 200 et en modifié une propriété, soit par filtration soit par modification de sa direction pour, par exemple, le faire converger vers la structure 130A, 130B, 130C correspondante. Ainsi chaque élément optique 210A, 210B, 210C peut être sélectionné dans le groupe comportant des filtres en longueurs d'onde et des lentilles. On notera que ces types d'élément optique étant bien connu de l'homme du métier, il n'y a pas lieu de les décrire plus en avant.

Selon une variante non illustrée de ce premier mode de réalisation, le deuxième support 200 peut être fonctionnalisé autrement qu'avec une pluralité d'éléments optiques, le deuxième support 200 comportant, par exemple un réseau de pistes conductrices destinées à permettre la connexion de troisièmes contacts métalliques des structures 130A, 130B, 130C disposés au niveau de la deuxième surface 110B du premier support 100. Selon cette variante, le deuxième support est réalisé dans un matériau transparent à la longueur d'onde de détection des structures 130A, 130B, 130C, et les pistes conductrices sont agencées de telle manière à ne pas interférer avec le rayonnement électromagnétique arrivant en direction de chacune des structures 130A, 130B, 130C. De la même manière, les pistes conductrices peuvent être réalisées dans un matériau transparent à la longueur d'onde de détection des structures 130A, 130B, 130C.

Cette variante étant parfaitement compatible avec la présence d'une pluralité d'éléments optiques 210A, 210B, 210C, selon une autre variante de ce premier mode de réalisation non illustrée, le deuxième support 200 peut comporter à la fois un réseau de piste conductrice, afin d'autoriser une connexion des troisièmes contact métallique des structures 130A, 130B, 130C, et des éléments optiques 210A, 210B, 210C, les pistes conductrices étant alors agencées entre les éléments optiques 210A, 210B, 210C.

Le deuxième support 200 étant aligné au premier support 100 au moyen de la marque d'alignement 140 du premier support 100. De cette manière, l'alignement entre chaque élément optique 210A, 210B, 210C et la structure 130A, 130B, 130C est fiable ave une interaction faible, voire nulle, entre un élément optique 210A, 210B, 210C et les structures 130A, 130B, 130C adjacentes à la structure correspondante qu'un mauvais alignement entraîne.

Le troisième support 300 comporte ;
- le circuit de commande et de traitement 320 adapté pour alimenter les structures 130A, 130B, 130C du premier support et traiter les signaux générés par ces dernières lorsqu'elles reçoivent un rayonnement électromagnétique dans la première gamme de longueurs d'onde,
- la pluralité de deuxièmes contacts métalliques 321A, 321B, 321C agencée sur une face du troisième support 300.

Les deuxièmes contacts métalliques 321A, 321B, 321C sont en contact électrique et mécanique, fournis par une hybridation par billes d'indiums 310A, 310B, 310C, avec les premiers contacts métalliques 132A, 132B, 132C correspondant du premier support 100.

Ce type de support de traitement dont fait partie le troisième support 300 étant connu de l'homme du métier et n'étant nullement l'objet de ce présent document, il n'y a pas lieu de le décrire plus avant.

Un tel composant optoélectronique 1 selon ce premier mode de réalisation peut être fourni par la mise en œuvre d'un procédé de fabrication comportant les étapes suivantes :
- fourniture du premier support 100 comprenant la couche semiconductrice 110,
- fourniture du troisième support 300,
- assemblage de la couche semiconductrice 110 par sa première surface 110A au troisième support 300 par hybridation par billes d'indium des contacts métalliques 132A, 132B, 132C,
- fourniture du deuxième support 200,
- assemblage du deuxième support 200 sur la deuxième face du premier support 100, l'alignement entre le premier et le deuxième support 100, 200 étant notamment obtenu par le moyen de la marque d'alignement 140 du premier support 100.

Bien entendu, l'ordre de ces étapes est fourni qu'à titre indicatif, l'assemblage du premier et du troisième support 100, 200 pouvant être, notamment, réalisé après l'étape d'assemblage. On notera également que certaines de ces étapes peuvent également être, sans que l'on sorte du cadre de l'invention, concomitantes. Ainsi, par exemple, comme cela va être décrit en lien avec les figures 3A à 3E, la fourniture du troisième support 300 et l'assemblage de la couche semiconductrice peuvent être réalisés dans le cadre de l'étape de fourniture du premier support 100.

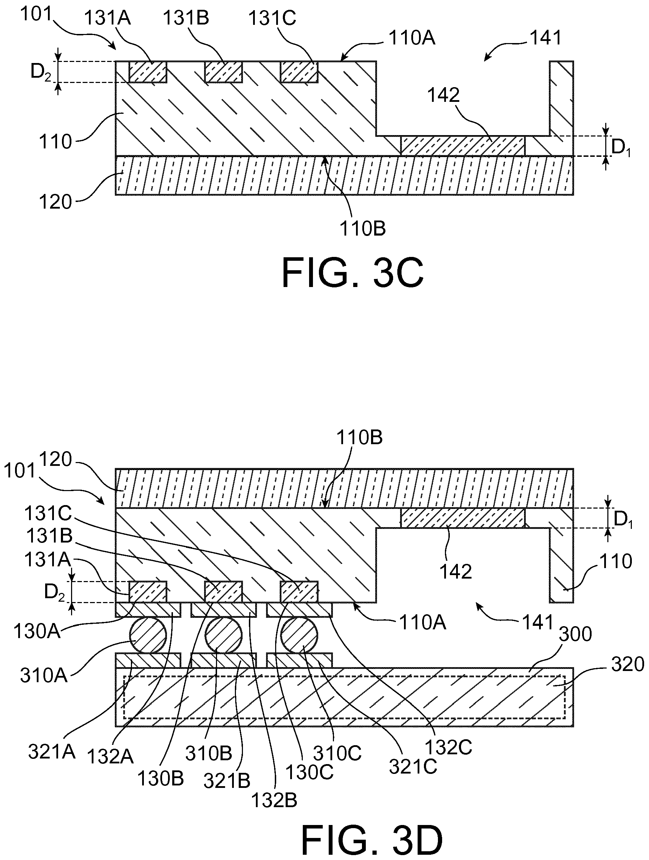

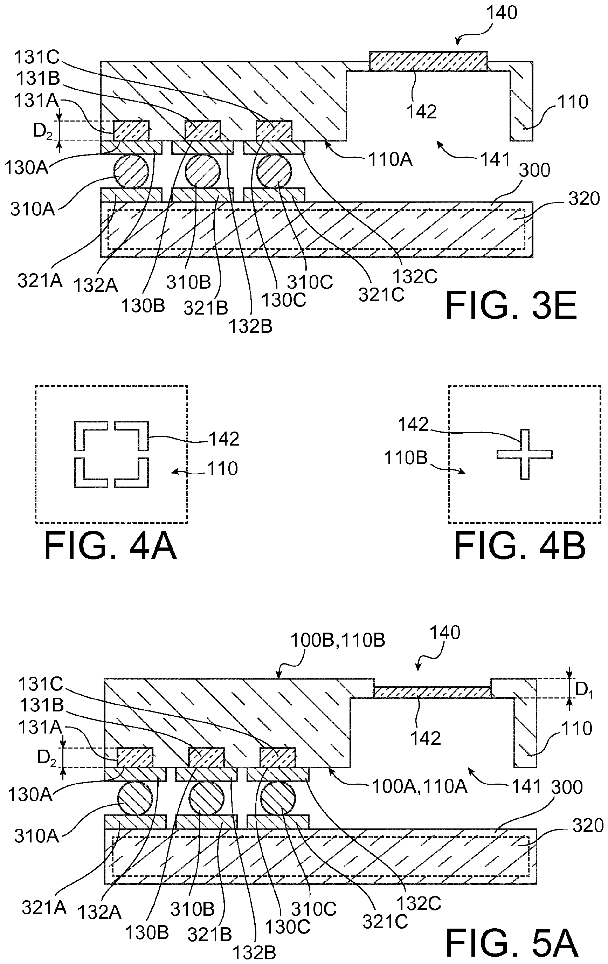

La fourniture du premier support 100 peut être obtenue, comme illustré sur les figures 3A à 3E, par la mise en œuvre d'un procédé de fabrication d'un tel premier support 100. Dans ce premier mode de réalisation, le procédé de fourniture d'un tel premier support comporte les étapes suivantes :
- fourniture d'un substrat 101, le substrat 101 comprenant une couche support 120 réalisée dans un premier matériau comprenant du cadmium Cd et une couche semiconductrice 110 présentant une première et une deuxième surface 110A, 110B et étant en contact avec la couche support 120 par sa deuxième surface 110B, la couche semiconductrice 110 étant réalisée dans le deuxième matériau qui, comprend une proportion atomique en cadmium x₂ plus faible à une proportion atomique en cadmium x₁ du premier matériau et présente un dopage N, comme illustré sur la figure 3A,
- formation d'une ouverture 141 dans la couche semiconductrice 110 à partir de la première surface 110A en direction de la deuxième surface 110B, une épaisseur restante de la couche semiconductrice 110 au niveau de l'ouverture 141 étant égale à D1, comme illustré sur la figure 3B,
- implantation localisée d'arsenic de la couche semiconductrice 110 au travers de la première surface 110A sur une pluralité de premier emplacements 131A, 131B, 131C de couche semiconductrice 110 et en un deuxième emplacement 142 situé dans l'ouverture 141 destinés à la formation de respectivement des structures 130A, 130B, 130C et d'une marque d'alignement, l'implantation localisée atteignant la deuxième surface 110B dans le deuxième emplacement 142,
- fourniture du troisième support 300,
- assemblage de la couche semiconductrice 110 par sa première surface 110A au troisième support 300 par hybridation par billes d'indium des contacts métalliques 132A, 132B, 132C,
- traitement thermique apte à activer l'arsenic implanté sur la pluralité de premier emplacement 131A, 131B, 131C pour former des zones dopées P et ainsi former la pluralité de structures 130A, 130B, 130C correspondant auxdites zones dopées 130A, 130B, 130C, le traitement thermique étant également adapté pour permettre une diffusion du cadmium de la couche support 120 vers le deuxième emplacement 142, ladite diffusion étant favorisée par l'arsenic implanté dans ledit deuxième emplacement 142 et permettant la fourniture de la marque d'alignement 140 affleurant la deuxième surface et avec une proportion atomique en cadmium x₃ supérieure à la proportion atomique en cadmium x₂ du reste de la couche semiconductrice 110 à la même distance de la deuxième surface (110B), comme illustré sur la figure 3D,
- suppression de la couche de support 120 et d'une partie de l'épaisseur de la couche semiconductrice 110 au moyen d'une gravure sensible à la proportion atomique en cadmium ceci de manière à ce que la deuxième surface 110B de la couche semiconductrice 110 présente une différence de hauteur entre la marque d'alignement 140, qui affleure la deuxième surface 110B et qui correspond au deuxième emplacement 142, et le reste de la deuxième surface 110B, la couche semiconductrice 110 ainsi libérée de la couche support 120 formant le premier support 100, la première et la deuxième surface 110A, 110B de la couche semiconductrice 110 formant les première et deuxième face 100A, 100B dudit premier support 100, comme illustré dans la figure 3E.

On notera que, comme cela a déjà été indiqué, dans ce premier mode de réalisation et lors de l'étape de suppression de la couche support 120 et d'une partie de la couche semiconductrice 110, la gravure sensible à la proportion de cadmium Cd est adaptée pour présenter une vitesse de gravure qui diminue lorsque la proportion en cadmium augmente. De cette manière, après l'étape de suppression de la couche support 120 et d'une partie de la couche semiconductrice 110, la marque d'alignement fait saillie du reste de la deuxième surface 110B de la couche semiconductrice 110.

On notera également que dans la configuration de ce premier mode de réalisation, telle qu'illustrée sur la figure 3C, l'implantation est réalisée sur les premiers emplacements et le deuxième emplacement lors d'une seule étape et ceci sur une profondeur D2 supérieure ou égale à D1, celle-ci étant égale à D1 dans la figure 3C.

En variante, l'implantation peut être réalisée en deux sous-étapes, une première sous-étape lors de laquelle l'implantation d'arsenic As est réalisée conjointement sur les premiers emplacements et le deuxième emplacement, et une deuxième étape sous-étape lors de laquelle l'implantation d'arsenic As est réalisée uniquement sur le deuxième emplacement. Pour réaliser une telle implantation en deux sous-étapes, il est possible d'utiliser un même masque d'implantation pour la première et la deuxième sous-étape, les ouvertures du masque correspondant aux premiers emplacements étant bouchées par l'utilisation, par exemple, d'un masque complémentaire. Selon cette variante, seule la deuxième sous étape correspondant à l'implantation complémentaire est nécessairement réalisée à une profondeur D2 supérieure ou égale à D1.

Les figures 4A et 4B illustrent deux exemples de forme, non limitatifs, de zones de marquage 140 compatibles avec le procédé de l'invention. Ainsi la marque d'alignement 140 illustrée sur la figure 4A est un carré présentant, au centre de chacun de ses côtés, une interruption. Selon le deuxième exemple, illustré sur la figure 4B, la marque d'alignement 140 peut prendre la forme d'une croix dont les dimensions peuvent être comprises entre 1 et 100 µm, voire entre 20 et 50 µm. Bien entendu, ces deux exemples sont purement indicatifs et tous types de forme connus de l'homme du métier pour permettre l'alignement d'un premier substrat par rapport à un deuxième substrat est bien entendu envisageable dans le cadre de l'invention.

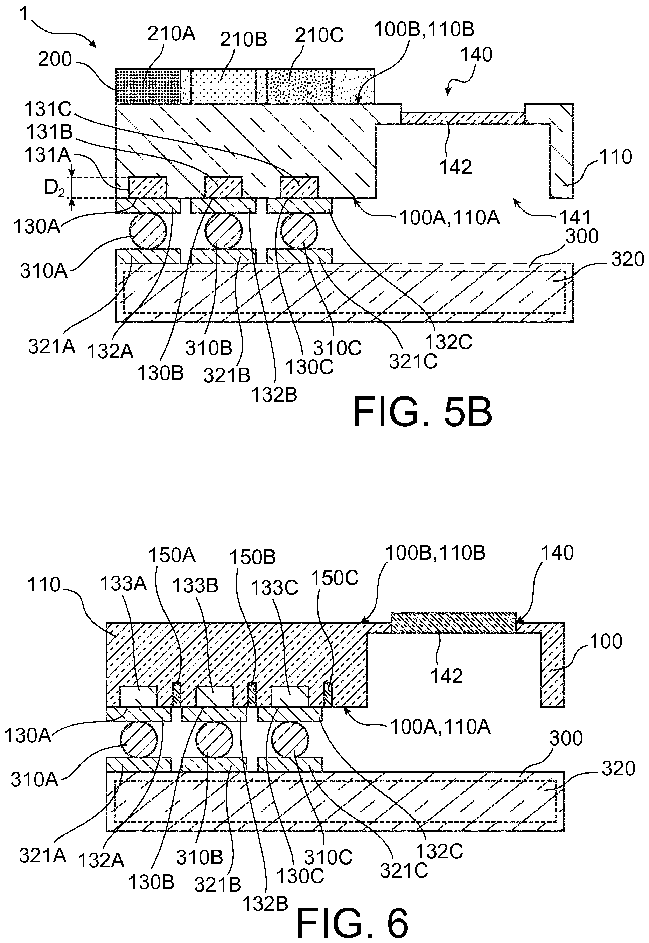

Les figures 5A et 5B illustrent en vue en coupe respectivement un premier support 100, assemblé à un troisième support 300, et un composant optoélectronique 1 selon un deuxième mode de réalisation de l'invention. Un composant optoélectronique 1 selon ce deuxième mode de réalisation se différencie d'un composant optoélectronique 1 selon le premier mode de réalisation en ce que la marque d'alignement 140 se présente sous la forme d'un creux vis-à-vis du reste de la deuxième surface 110B de la couche semiconductrice 110.

Ainsi, dans ce deuxième mode de réalisation la marque d'alignement 140 présente sous la forme d'un creux vis-à-vis du reste de la deuxième surface 110B de la couche semiconductrice 110. Une telle forme de la marque d'alignement 140 est fournie en utilisant, lors de l'étape de suppression de la couche support 120 et d'une partie de la couche semiconductrice 110, une gravure sensible à la proportion de cadmium Cd qui est adaptée pour présenter une vitesse de gravure qui augmente lorsque la proportion atomique en cadmium augmente.

Une telle gravure peut être, par exemple, une gravure chimique en voie humide à partir d'une solution acide comprenant un oxyde de chrome. En effet, comme l'ont démontré les travaux de J. D. Benson et ses coauteurs publiés en 2010 dans la revue scientifique « Journal of Electronic Materials » Volume 39 numéro 7 pages 1080 à 1086, une gravure à partir d'une telle solution présente une vitesse de gravure de matériaux comprenant du cadmium qui augmente avec l'augmentation de la proportion atomique en cadmium. On notera que J. D. Benson on notamment utilisé pour faire une telle démonstration une solution comprenant de l'eau H₂O, de l'acide nitrique HNO₃, de l'acide fluorhydrique HF, de l'acide chlorhydrique HCI et du trioxyde de chlore CrO₃.

Ainsi le procédé de fabrication d'un composant 1 selon ce deuxième mode de réalisation se différencie d'un procédé selon le premier mode de réalisation en ce que lors de l'étape de suppression de la couche support 120 et d'une partie de la couche semiconductrice 110, la gravure sensible à la proportion de cadmium Cd est adaptée pour présenter une vitesse de gravure qui augmente lorsque la proportion atomique en cadmium augmente.

La figure 6 illustre un composant optoélectronique 1 selon un troisième mode de réalisation dans lequel la couche semiconductrice 110 est dopée P, les structures 130A, 130B, 130C comprenant une deuxième zone 133A, 133B, 133C dopée N pour chacune d'entre elle et des zones dopées P formant des lignes d'isolations des structures 130A, 130B, 130C. Ces lignes peuvent également former un réseau de conduction pour polariser uniformément la couche semiconductrice 110. Un composant optoélectronique 1 selon ce troisième mode de réalisation se différencie d'un composant optoélectronique 1 selon le premier mode de réalisation en ce que :
- la couche semiconductrice 110 est dopée P et donc comporte le deuxième type de conductivité,
- la marque d'alignement présente une concentration en porteurs majoritaires supérieure à celle de la couche semiconductrice 110,
- les structure 130A, 130B, 130C, chacune des structures 130A, 130B, 130C comportant :
   ∘ une deuxième zone 133A, 133B, 133C dopée N pour former, avec le reste de la couche semiconductrice une diode,
   ∘ les zones dopées 150A, 150B, 150C présentant un dopage P, ceci avec une concentration en porteurs majoritaires supérieures à celle de la couche semiconductrice 110, et formant des lignes de conduction et d'isolation s'interposant entre ladite structure et les structures adjacentes,
   ∘ un premier contact métallique 132A, 132B, 132C de la deuxième zone 133A, 133B, 133C,
   ∘ un troisième contact métallique, préférentiellement commun à au moins un groupe de structures, non illustré des zones dopées P.

Ainsi, dans ce troisième mode de réalisation, la couche semiconductrice 110 présente un dopage P avec une concentration en éléments dopants accepteurs d'électrons comprise entre 5.10¹⁵ et 1.10¹⁷ cm⁻³.

Les zones dopées 150A, 150B, 150C présentent une concentration en arsenic, donc en éléments dopants accepteurs d'électrons, compris entre 5.10¹⁷ et 1.10¹⁹ cm⁻³. Ces zones dopées 150A, 150B, 150C sont agencées de manière à délimiter chacune des structures et à les isoler les unes des autres afin de limiter, voire supprimer les phénomènes de diaphonie (connus en langue anglaise sous la dénomination de « Crosstalk »). Dans ce troisième mode de réalisation, les zones dopées présentent une épaisseur comprise entre 0,1 et 1 µm.

Pour plus d'information concernant la configuration d'une structure selon ce troisième mode de réalisation, il est renvoyé au document WO 2013/079447 qui concerne des structures comportant de telles lignes de conduction.

De manière similaire aux zones dopées, la marque d'alignement présente un dopage supérieur à celui de la couche semiconductrice 110. Ainsi la marque d'alignement peut présenter une concentration en arsenic, donc en éléments dopants accepteurs d'électrons, compris entre 5.10¹⁷ et 1.10¹⁹ cm⁻³.

Le procédé de fabrication d'un composant selon ce troisième mode de réalisation se différencie d'un procédé de fabrication selon le premier mode de réalisation en ce qu'il comporte en outre une étape de formation des deuxième zones 133A, 133B, 133C dopée N et en ce que lors de l'étape d'implantation en arsenic As, les premiers emplacements sont agencés de manière à délimiter chacune des structures.

En variante à ce troisième mode de réalisation, conformément à l'enseignement du document WO 2013/079447, les zones dopées peuvent être agencées pour délimiter des ensembles de structures 130A, 130B, 130C, par exemple un ensemble de quatre structures.

On notera que, quelques soient le mode de réalisation, lors de l'étape d'implantation sur les premiers emplacements et le deuxième emplacement, les premiers emplacements correspondent à une zones destinées à la formation et/ou la délimitation d'au moins une structure 130A, 130B, 130C du composant optoélectronique 1.

## Revendications

1. Procédé de fabrication d'un premier support (100) destiné à former, avec notamment un deuxième support (200), un composant optoélectronique (1), le premier support (100) présentant une première et une deuxième face (100A, 100B) et comprenant une pluralité de structures (130A, 130B, 130C) du type diode dont au moins un contact métallique affleure de la première surface (100A), et une marque d'alignement (140) sur la deuxième face (100B) apte à permettre un alignement avec le deuxième support (200) lors de l'assemblage du premier support (100) par sa deuxième face (100A) au deuxième support (200) pour la formation du composant optoélectronique (1),
le procédé comprenant les étapes suivantes de :
- fourniture d'un substrat (101), le substrat (101) comprenant une couche support (120) réalisée dans un premier matériau comprenant du cadmium, et une couche semiconductrice (110) présentant une première et une deuxième surface (110A, 110B) et étant en contact avec la couche support (120) par la deuxième surface (110B) de ladite couche semiconductrice (110), la couche semiconductrice (110) étant réalisée dans un deuxième matériau comprenant une proportion atomique en cadmium x₂ plus faible à une proportion atomique en cadmium x₁ du premier matériau,
- formation d'une ouverture (141) dans la couche semiconductrice (110) à partir de la première surface (110A) en direction de la deuxième surface (110B),
- implantation localisée d'arsenic de la couche semiconductrice (110) au travers de la première surface (110A) sur une pluralité de premiers emplacements (131A, 131B, 131C) de la couche semiconductrice (110) et en un deuxième emplacement (142) situé dans l'ouverture (141) destinés à la formation de respectivement les structures (130A, 130B, 130C) et d'une marque d'alignement, l'implantation localisée atteignant la deuxième surface (110B) dans le deuxième emplacement (142),
- traitement thermique apte à activer l'arsenic implanté sur la pluralité de premiers emplacements (131A, 131B, 131C) pour former des zones dopées d'un deuxième type de conductivité dans lequel les porteurs majoritaires sont des trous, lesdites zones dopées participant à la formation des structures (130A, 130B, 130C) correspondant auxdites zones dopées, le traitement thermique étant également adapté pour permettre une diffusion du cadmium de la couche support (120) vers le deuxième emplacement (142), ladite diffusion étant favorisée par l'arsenic implanté dans ledit deuxième emplacement (142) et permettant la fourniture de la marque d'alignement (140) affleurant la deuxième surface (110B) et qui présente une proportion atomique en cadmium x₃ supérieure à la proportion atomique en cadmium x₂ du reste de la couche semiconductrice (110) à la même distance de la deuxième surface (110B),
- suppression de la couche de support (120) et d'une partie de l'épaisseur de la couche semiconductrice (110) au moyen d'une gravure sensible à la proportion atomique en cadmium ceci de manière à ce que la deuxième surface (110B) de la couche semiconductrice (110) présente une différence de hauteur entre la marque d'alignement (140), qui affleure la deuxième surface (110B) et qui correspond au deuxième emplacement (142), et le reste de la deuxième surface (110B), la couche semiconductrice (110) ainsi libérée de la couche support (120) formant le premier support (100), la première et la deuxième surface (110A, 110B) de la couche semiconductrice (110) formant les première et deuxième faces (100A, 100B) dudit premier support (100).

2. Procédé de fabrication d'un premier support (100) selon la revendication 1, dans lequel le premier matériau comprend au moins un premier élément de la colonne VI du tableau périodique et au moins un deuxième élément de la colonne II du tableau périodique dont le cadmium, le cadmium présentant une proportion atomique x₁ du ou desdits deuxièmes éléments de la colonne II du premier matériau supérieure à 80% et préférentiellement supérieure à 90% voire à 95%.

3. Procédé de fabrication d'un premier support (100) selon la revendication 2, dans lequel le deuxième matériau comprend au moins un troisième élément de la colonne VI du tableau périodique et au moins deux quatrièmes éléments de la colonne II du tableau périodique, l'un des quatrièmes éléments étant le cadmium, le ou les troisièmes éléments pouvant être identiques, distincts ou partiellement distincts du ou des premier éléments, et le ou les quatrièmes éléments, outre le cadmium qui est commun, pouvant être identiques, distincts ou partiellement distincts du ou des deuxièmes éléments,
dans lequel le deuxième matériau présente une proportion atomique en cadmium x₂ desdits quatrième éléments de la colonne II du deuxième matériau inférieure d'au moins 20%, préférentiellement 30%, voire 40%, à la proportion atomique du cadmium x₁ du ou desdits deuxièmes éléments.

4. Procédé de fabrication d'un premier support (100) selon la revendication 2 et 3, dans lequel le premier matériau est sélectionné dans le groupe comportant du tellurure de cadmium, des tellurures de cadmium et zinc du type Cdₓ₁Zn₁₋ₓ₁Te, les séléniures-tellurures de cadmium du type CdTeₓSe₁₋ₓ, et leurs alliages,
et dans lequel le deuxième matériau est un tellurure de mercure-cadmium du type Cdₓ₂Hg₁₋ₓ₂Te.

5. Procédé de fabrication d'un premier support (100) selon l'une quelconque des revendications 1 à 4, dans lequel lors de l'étape formation d'une ouverture (141), une épaisseur restante D1 de la couche semiconductrice (110) au niveau de l'ouverture (141) est comprise entre 0,1 et 2 µm, préférentiellement entre 0,2 et 1 µm, voire 0,4 et 0,8 µm et peut être, par exemple, égale à 0,5 µm.

6. Procédé de fabrication selon l'une quelconque des revendications, dans lequel l'étape implantation localisée d'arsenic de la couche semiconductrice (110) comprend les sous-étapes suivantes :
- première implantation localisée de la couche semiconductrice (110) sur les premiers emplacements et le deuxième emplacement,
- deuxième implantation complémentaire de la couche semiconductrice (110) uniquement sur le deuxième emplacement (140).

7. Procédé de fabrication d'un premier support (100) selon l'une quelconque des revendications 1 à 6, dans lequel lors de l'étape de suppression de la couche de support (120) et d'une partie de l'épaisseur de la couche semiconductrice (110), la gravure sélective est une gravure plasma hydrocarboné de manière à fournir une marque d'alignement faisant saillie du reste de la deuxième surface de la couche semiconductrice, le plasma utilisé pour la gravure étant préférentiellement à base de méthane et de dihydrogène.

8. Procédé de fabrication d'un premier support (100) selon l'une quelconque des revendications 1 à 6, dans lequel lors de l'étape de suppression de la couche de support (120) et d'une partie de l'épaisseur de la couche semiconductrice (110), la gravure est une gravure chimique en voie humide à partir d'une solution acide comprenant un oxyde de chrome de manière à fournir une marque d'alignement sous la forme d'un creux vis-à-vis du reste de la deuxième surface de la couche semiconductrice.

9. Procédé de fabrication d'un composant optoélectronique (1) comprenant les étapes suivantes :
- fourniture d'un premier support (100) par la mise en œuvre d'un procédé de fabrication d'un premier support selon l'une quelconque des revendications 1 à 8,
- fourniture d'un deuxième support (200),
- assemblage du premier et du deuxième support (100, 200), le deuxième support (200) étant aligné au premier support (100) au moyen de la marque d'alignement (140).

10. Procédé de fabrication d'un composant optoélectronique (1) selon la revendication 9, dans lequel il est en outre prévu lors de la mise en œuvre du procédé de fabrication d'un premier support (100) une étape de formation sur la première surface (110A) de la couche semiconductrice (110) des premiers contacts métalliques (132A, 132B, 132C) de chacune des structures (130A, 130B, 130C),
le procédé de fabrication d'un composant optoélectronique (1) comportant, que ce soit en tant que tel ou lors de la mise en œuvre du procédé de fabrication d'un premier support (100), les étapes suivantes :
- fourniture d'un troisième support (300) comportant un circuit électronique de commande et de traitement et des deuxièmes contacts métalliques en correspondance avec les premiers contacts métalliques,
- assemblage du premier et du troisième support (100, 300) par une opération de soudage ou de brasage des premiers contacts sur les deuxièmes contacts, l'assemblage du premier et du troisième support (100, 300) se faisant préférentiellement par hybridation par billes d'indium (310A, 310B, 310C).

11. Procédé de fabrication d'un composant optoélectronique (1) selon la revendication 9 ou 10, dans lequel le deuxième support comprend une pluralité d'éléments fonctionnels (210A, 210B, 210C), les éléments fonctionnels du deuxième support étant sélectionnés parmi les éléments optiques dont font partis les filtres en longueurs d'onde et les systèmes de concentration optique, et les éléments de connexion, tels que des pistes de connexion,
et dans lequel lors de l'assemblage du premier et du deuxième support (100, 200), l'alignement du deuxième support (200) au moyen de la marque d'alignement (140) permet d'aligner chaque élément fonctionnel (210A, 210B, 210C) à la structure (130A, 130B, 130C) correspondante.

12. Premier support (100) destiné à former, notamment avec un deuxième support (200), un composant optoélectronique (1), le premier support (100) présentant une première et une deuxième face (100A, 100B, 100C) et comprenant une couche semiconductrice (110) formant ledit premier support (100), la couche semiconductrice (110) présentant une première et une deuxième surface (110A, 110B) formant respectivement la première et la deuxième face (100A, 100B) du premier support (100), la couche semiconductrice (110) étant réalisée dans un deuxième matériau qui, comprend une proportion en cadmium x₂,
dans lequel la couche semiconductrice (110) comprend :
- une pluralité de structures (130A, 130B, 130C) du type diode dont au moins un contact métallique affleure de la première surface (110A), les structures (130A, 130B, 130C) comportant des zones dopées (131A, 131B, 131C) chacune en un premier emplacement respectif de la couche semiconductrice (110), chaque zone dopée (131A, 131B, 131C) présentant un deuxième type de conductivité dans lequel les trous sont les porteurs majoritaires, ce deuxième type de conductivité étant fourni au moyen d'un dopage à l'arsenic, et
une ouverture (140) aménagée dans la couche semiconductrice (110) à partir de la première surface (110A) en direction de la deuxième surface (110B),
le premier support (100) **étant caractérisé en ce que** la couche semiconductrice (110) comprend en outre :
- une marque d'alignement (140) formée en un deuxième emplacement (141) situé dans l'ouverture, la marque d'alignement (140) présentant le deuxième type de conductivité, le deuxième type de conductivité étant fourni au moyen d'un dopage à l'arsenic débouchant sur la deuxième surface (110B), et une proportion en cadmium moyenne x₃ supérieure à la proportion en cadmium moyenne x₂ du deuxième matériau à la même distance de la deuxième surface (110B), la marque d'alignement (140) affleurant la deuxième surface (110B) de la couche semiconductrice (110),
et **en ce que** la deuxième surface (110B) de la couche semiconductrice (110) présente une différence de hauteur entre la marque d'alignement (140), qui affleure de deuxième surface (110B) et qui correspond au deuxième emplacement (141), et le reste de la deuxième surface (110B).

13. Premier support selon la revendication 12 dans lequel la marque d'alignement (140) se présente sous la forme d'un creux- vis-à-vis du reste de la deuxième surface (110B) de la couche semiconductrice (110).

14. Premier support selon la revendication 12 dans lequel la marque d'alignement (140) est en saillie vis-à-vis du reste de la deuxième surface (110B) de la couche semiconductrice (110).

15. Composant optoélectronique (1) comprenant :
- un premier support (100) selon l'une quelconque des revendications 12 à 14,
- un deuxième support (200),
dans lequel le premier support (100) est assemblé par sa deuxième face (100A) au deuxième support (200) en étant aligné avec ce dernier.

## Patentansprüche

1. Verfahren zur Herstellung eines ersten Trägers (100), der dazu bestimmt ist, mit insbesondere einem zweiten Träger (200) ein optoelektronisches Bauteil (1) zu bilden, wobei der erste Träger (100) eine erste und eine zweite Seite (100A, 100B) aufweist und eine Vielzahl von Strukturen (130A, 130B, 130C) vom Diodentyp enthält, von denen zumindest ein Metallkontakt mit der ersten Seite (100A) bündig verläuft, sowie eine Ausrichtungsmarkierung (140) an der zweiten Seite (100B), die geeignet ist, beim Anfügen des ersten Trägers (100) mit seiner zweiten Seite (100A) an den zweiten Träger (200) zur Bildung des optoelektronischen Bauteils (1) eine Ausrichtung mit dem zweiten Träger (200) zu ermöglichen, wobei das Verfahren die folgenden Schritte umfasst: :
- Bereitstellen eines Substrats (101), wobei das Substrat (101) eine Trägerschicht (120) aus einem ersten Material, das Cadmium enthält, und eine Halbleiterschicht (110) mit einer ersten und einer zweiten Oberfläche (110A, 110B) aufweist, die mit der zweiten Oberfläche (110B) der Halbleiterschicht (110) in Kontakt mit der Trägerschicht (120) steht, wobei die Halbleiterschicht (110) aus einem zweiten Material hergestellt ist, das einen kleineren Atomanteil an Cadmium x₂ als ein Atomanteil an Cadmium x₁ des ersten Materials aufweist,
- Ausbilden einer Öffnung (141) in der Halbleiterschicht (110) ausgehend von der ersten Oberfläche (110A) in Richtung zur zweiten Oberfläche (110B),
- bereichsweise Implantation von Arsen der Halbleiterschicht (110) durch die erste Oberfläche (110A) hindurch an einer Vielzahl von ersten Stellen (131A, 131B, 131C) der Halbleiterschicht (110) und an einer zweiten Stelle (142), die sich in der Öffnung (141) befindet, zur jeweiligen Bildung der Strukturen (130A, 130B, 130C) und einer Ausrichtungsmarkierung, wobei die bereichsweise Implantation die zweite Oberfläche (110B) an der zweiten Stelle (142) erreicht,
- Wärmebehandlung, die dazu geeignet ist, das Arsen zu aktivieren, das an der Vielzahl von ersten Stellen (131A, 131B, 131C) implantiert ist, um dotierte Bereiche eines zweiten Leitfähigkeitstyps zu bilden, bei dem die Majoritätsträger Löcher sind, wobei die dotierten Bereiche an der Bildung der Strukturen (130A, 130B, 130C) mitwirken, die den dotierten Bereichen entsprechen, wobei die Wärmebehandlung auch dazu geeignet ist, eine Diffusion von Cadmium von der Trägerschicht (120) zur zweiten Stelle (142) hin zu ermöglichen, wobei die Diffusion durch das an der zweiten Stelle (142) implantierte Arsen begünstigt wird und das Bereitstellen der Ausrichtungsmarkierung (140) ermöglicht, die bündig mit der zweiten Oberfläche (110B) verläuft und einen höheren Atomanteil an Cadmium x₃ als der Atomanteil an Cadmium x₂ der restlichen Halbleiterschicht (110) im gleichen Abstand von der zweiten Oberfläche (110B) aufweist,
- Entfernen der Trägerschicht (120) und eines Teils der Dicke der Halbleiterschicht (110) mittels einer für den Atomanteil an Cadmium empfindlichen Ätzung, so dass die zweite Oberfläche (110B) der Halbleiterschicht (110) einen Höhenunterschied zwischen der Ausrichtungsmarkierung (140) aufweist, die mit der zweiten Oberfläche (110B) bündig verläuft und die der zweiten Stelle (142) entspricht, und der restlichen zweiten Oberfläche (110B) aufweist, wobei die so von der Trägerschicht (120) gelöste Halbleiterschicht (110) den ersten Träger (100) bildet, wobei die erste und die zweite Oberfläche (110A, 110B) der Halbleiterschicht (110) die erste und die zweite Seite (100A, 100B) des ersten Trägers (100) bilden.

2. Verfahren zur Herstellung eines ersten Trägers (100) nach Anspruch 1, wobei das erste Material zumindest ein erstes Element aus Spalte VI des Periodensystems der Elemente und zumindest ein zweites Element aus Spalte II des Periodensystems der Elemente einschließlich Cadmium enthält, wobei das Cadmium einen Atomanteil x₁ des bzw. der zweiten Elemente aus Spalte II des ersten Materials von mehr als 80 % und vorzugsweise mehr als 90 % oder sogar 95 % aufweist.

3. Verfahren zur Herstellung eines ersten Trägers (100) nach Anspruch 2, wobei das zweite Material zumindest ein drittes Element aus Spalte VI des Periodensystems und zumindest zwei vierte Elemente aus Spalte II des Periodensystems enthält, wobei eines der vierten Elemente Cadmium ist, wobei das bzw. die dritten Element(e) identisch, verschieden oder teilweise verschieden von dem bzw. den ersten Element(en) sein können, und das bzw. die vierten Element(e) neben dem gemeinsamen Cadmium identisch, verschieden oder teilweise verschieden von dem bzw. den zweiten Element(en) sein kann bzw. können,
wobei das zweite Material einen Atomanteil an Cadmium x₂ der vierten Elemente aus Spalte II des zweiten Materials aufweist, der zumindest 20%, vorzugsweise 30% oder sogar 40% niedriger als der Atomanteil an Cadmium x₁ des bzw. der zweiten Element(e) ist.

4. Verfahren zur Herstellung eines ersten Trägers (100) nach den Anspruch 2 und 3, wobei das erste Material ausgewählt ist aus der Gruppe bestehend aus Cadmiumtellurid, Cadmiumzinktelluriden des Typs Cdₓ₁Zn₁₋ₓ₁Te, Cadmiumselenid-Telluriden des Typs CdTeₓSe₁₋ₓ und deren Legierungen, und wobei das zweite Material ein Quecksilber-Cadmiumtellurid des Typs Cdx2Hgi-x2Te ist.

5. Verfahren zur Herstellung eines ersten Trägers (100) nach einem der Ansprüche 1 bis 4, wobei in dem Schritt des Ausbildens einer Öffnung (141) eine Restdicke D1 der Halbleiterschicht (110) an der Öffnung (141) zwischen 0,1 und 2 µm, vorzugsweise zwischen 0,2 und 1 µm bzw. 0,4 und 0,8 µm, liegt und beispielsweise im Wesentlichen gleich 0,5 µm sein kann.

6. Herstellungsverfahren nach einem der Ansprüche, wobei der Schritt der bereichsweisen Arsenimplantation der Halbleiterschicht (110) die folgenden Teilschritte umfasst:
- erste bereichsweise Implantation der Halbleiterschicht (110) an den ersten Stellen und an der zweiten Stelle,
- zweite komplementäre Implantation der Halbleiterschicht (110) nur an der zweiten Stelle (140).

7. Verfahren zur Herstellung eines ersten Trägers (100) nach einem der Ansprüche 1 bis 6, wobei in dem Schritt des Entfernens der Trägerschicht (120) und eines Teils der Dicke der Halbleiterschicht (110) das selektive Ätzen ein Ätzen mit Kohlenwasserstoffplasma ist, um so eine Ausrichtungsmarkierung bereitzustellen, die von der restlichen zweiten Oberfläche der Halbleiterschicht vorsteht, wobei das für das Ätzen verwendete Plasma vorzugsweise auf Basis von Methan und Dihydrogen besteht.

8. Verfahren zur Herstellung eines ersten Trägers (100) nach einem der Ansprüche 1 bis 6, wobei in dem Schritt des Entfernens der Trägerschicht (120) und eines Teils der Dicke der Halbleiterschicht (110) das Ätzen ein chemisches Nassätzen aus einer sauren, Chromoxid enthaltenden Lösung ist, um eine Ausrichtungsmarkierung in Form einer Vertiefung bezüglich der restlichen der zweiten Oberfläche der Halbleiterschicht zu schaffen.

9. Verfahren zur Herstellung eines optoelektronischen Bauteils (1), das die folgenden Schritte umfasst:
- Bereitstellen eines ersten Trägers (100) durch Durchführen eines Verfahrens zur Herstellung eines ersten Trägers nach einem der Ansprüche 1 bis 8,
- Bereitstellen eines zweiten Trägers (200),
- Zusammenfügen des ersten und des zweiten Trägers (100, 200), wobei der zweite Träger (200) mit Hilfe der Ausrichtungsmarkierung (140) mit dem ersten Träger (100) ausgerichtet wird.

10. Verfahren zur Herstellung eines optoelektronischen Bauteils (1) nach Anspruch 9, wobei bei der Durchführung des Verfahrens zur Herstellung eines ersten Trägers (100) ferner ein Schritt zur Bildung erster Metallkontakte (132A, 132B, 132C) jeder der Strukturen (130A, 130B, 130C) an der ersten Oberfläche (110A) der Halbleiterschicht (110) vorgesehen ist,
wobei das Verfahren zur Herstellung eines optoelektronischen Bauteils (1) entweder als solches oder bei der Durchführung des Verfahrens zur Herstellung eines ersten Trägers (100) die folgenden Schritte umfasst:
- Bereitstellen eines dritten Trägers (300) mit einer elektronischen Steuer- und Verarbeitungsschaltung und zweiten Metallkontakten in Übereinstimmung mit den ersten Metallkontakten,
- Zusammenfügen des ersten und des dritten Trägers (100, 300) durch einen Schweiß- oder Lötvorgang der ersten Kontakte mit den zweiten Kontakten, wobei das Zusammenfügen des ersten und des dritten Trägers (100, 300) vorzugsweise durch Hybridisierung unter Verwendung von Indiumkugeln (310A, 310B, 310C) erfolgt.

11. Verfahren zur Herstellung eines optoelektronischen Bauteils (1) nach Anspruch 9 oder 10, wobei der zweite Träger eine Vielzahl von Funktionselementen (210A, 210B, 210C) enthält, wobei die Funktionselemente des zweiten Trägers aus optischen Elementen, zu denen Wellenlängenfilter und optische Fokussierungssysteme gehören, und Verbindungselementen, wie beispielsweise Verbindungsbahnen, ausgewählt sind,
und wobei beim Zusammenfügen des ersten und des zweiten Trägers (100, 200) die Ausrichtung des zweiten Trägers (200) mittels der Ausrichtungsmarkierung (140) es ermöglicht, jedes Funktionselement (210A, 210B, 210C) mit der entsprechenden Struktur (130A, 130B, 130C) auszurichten.

12. Erster Träger (100), der dazu bestimmt ist, insbesondere mit einem zweiten Träger (200) ein optoelektronisches Bauteil (1) zu bilden, wobei der erste Träger (100) eine erste und eine zweite Seite (100A, 100B, 100C) aufweist und eine Halbleiterschicht (110) enthält, die den ersten Träger (100) bildet, wobei die Halbleiterschicht (110) eine erste und eine zweite Oberfläche (110A, 110B) aufweist, die jeweils die erste und die zweite Seite (100A, 100B) des ersten Trägers (100) bilden, wobei die Halbleiterschicht (110) aus einem zweiten Material hergestellt ist, das einen Cadmium-Anteil x₂ aufweist, wobei die Halbleiterschicht (110) enthält:
- eine Vielzahl von Strukturen (130A, 130B, 130C) vom Diodentyp, von denen zumindest ein Metallkontakt mit der ersten Oberfläche (110A) bündig verläuft, wobei die Strukturen (130A, 130B, 130C) dotierte Bereiche (131A, 131B, 131C) jeweils an einer jeweiligen ersten Stelle der Halbleiterschicht (110) aufweisen, wobei jeder dotierte Bereich (131A, 131B, 131C) einen zweiten Leitfähigkeitstyp aufweist, bei dem die Löcher die Majoritätsträger sind, wobei dieser zweite Leitfähigkeitstyp durch eine Arsendotierung bereitgestellt ist, wobei eine Öffnung (140) in der Halbleiterschicht (110) von der ersten Oberfläche (110A) in Richtung der zweiten Oberfläche (110B) eingebracht ist, wobei der erste Träger (100) **dadurch gekennzeichnet ist, dass** die Halbleiterschicht (110) ferner enthält
- eine Ausrichtungsmarkierung (140), die an einer zweiten Stelle (141) in der Öffnung ausgebildet ist, wobei die Ausrichtungsmarkierung (140) den zweiten Leitfähigkeitstyp aufweist, wobei der zweite Leitfähigkeitstyp mittels einer Arsendotierung bereitgestellt ist, die in die zweite Oberfläche (110B) mündet, sowie einen höheren durchschnittlichen Kadmiumanteil x₃ als der durchschnittliche Kadmiumanteil x₂ des zweiten Materials im gleichen Abstand von der zweiten Oberfläche (110B), wobei die Ausrichtungsmarkierung (140) bündig mit der zweiten Oberfläche (110B) der Halbleiterschicht (110) verläuft, und dass die zweite Oberfläche (110B) der Halbleiterschicht (110) einen Höhenunterschied zwischen der Ausrichtungsmarkierung (140), die mit der zweiten Oberfläche (110B) bündig verläuft und die der zweiten Stelle (142) entspricht, und der restlichen zweiten Oberfläche (110B) aufweist.

13. Erster Träger nach Anspruch 12, wobei die Ausrichtungsmarkierung (140) in Form einer Vertiefung bezüglich der restlichen zweiten Oberfläche (110B) der Halbleiterschicht (110) vorliegt.

14. Erster Träger nach Anspruch 12, wobei die Ausrichtungsmarkierung (140) gegenüber der restlichen zweiten Oberfläche (110B) der Halbleiterschicht (110) vorsteht.

15. Optoelektronisches Bauteil (1), enthaltend:
- einen ersten Träger (100) nach einem der Ansprüche 12 bis 14,
- einen zweiten Träger (200),
wobei der erste Träger (100) an seiner zweiten Seite (100A) mit dem zweiten Träger (200) unter Ausrichtung mit diesem zusammengefügt ist.

## Claims

1. A method for manufacturing a first support (100) for forming, in particular with a second support (200), an optoelectronic component (1), the first support (100) having a first and a second face (100A, 100B) and comprising a plurality of diode type structures (130A, 130B, 130C) at least one metal contact of which flushes with the first surface (100A), and an alignment mark (140) on the second face (100B) able to allow alignment with the second support (200) upon assembling the first support (100) through its second face (100A) to the second support (200) for forming the optoelectronic component (1),
the method comprising the following steps of:
- providing a substrate (101), the substrate (101) comprising a support layer (120) made of a first material comprising cadmium, and a semiconductor layer (110) having a first and a second surface (110A, 110B) and being in contact with the support layer (120) through the second surface (110B) of said semiconductor layer (110), the semiconductor layer (110) being made of a second material comprising a cadmium atomic proportion x₂ lower than a cadmium atomic proportion x₁ of the first material,
- forming an aperture (141) in the semiconductor layer (110) from the first surface (110A) towards the second surface (110B),
- implanting in a localised manner arsenic of the semiconductor layer (110) through the first surface (110A) on a plurality of first locations (131A, 131B, 131C) of the semiconductor layer (110) and at a second location (142) located in the aperture (141) for forming respectively the structures (130A, 130B, 130C) and an alignment mark, the localised implantation reaching the second surface (110B) in the second location (142),
- heat treating able to activate the implanted arsenic on the plurality of first locations (131A, 131B, 131C) to form doped zones of a second conductivity type in which the majority carriers are holes, said doped zones participating in forming the structures (130A, 130B, 130C) corresponding to said doped zones, the heat treatment being also adapted to allow cadmium diffusion from the support layer (120) to the second location (142), said diffusion being promoted by the arsenic implanted in said second location (142) and allowing providing the alignment mark (140) flushing with the second surface (110B) and which has a cadmium atomic proportion x₃ higher than the cadmium atomic proportion x₂ of the rest of the semiconductor layer (110) at the same distance from the second surface (110B),
- removing the support layer (120) and a part of the thickness of the semiconductor layer (110) by means of an etching sensitive to the cadmium atomic proportion such that the second surface (110B) of the semiconductor layer (110) has a height difference between the alignment mark (140), which flushes with the second surface (110B) and which corresponds to the second location (142), and the rest of the second surface (110B), the semiconductor layer (110) thus released from the support layer (120) forming the first support (100), the first and the second surface (110A, 110B) of the semiconductor layer (110) forming the first and second faces (100A, 100B) of said first support (100).

2. The method for manufacturing a first support (100) according to claim 1, wherein the first material comprises at least one first element of column VI of the periodic table and at least one second element of column II of the periodic table including cadmium, cadmium having an atomic proportion x₁ of the or said second element(s) of column II of the first material higher than 80% and preferentially higher than 90% or even 95%.

3. The method for manufacturing a first support (100) according to claim 2, wherein the second material comprises at least one third element of column VI of the periodic table and at least two fourth elements of column II of the periodic table, one of the fourth elements being cadmium, the third element(s) being possibly identical, distinct or partially distinct from the first element(s), and the fourth element(s), in addition to cadmium which is common, being possibly identical, distinct or partially distinct from the second element(s),
wherein the second material has a cadmium atomic proportion x₂ of said fourth elements of column II of the second material lower by at least 20%, preferentially 30%, or even 40%, than the cadmium atomic proportion x₁ of the or said second element(s).

4. The method for manufacturing a first support (100) according to claim 2 and 3, wherein the first material is selected from the group including cadmium telluride, cadmium and zinc tellurides of the type Cdₓ₁Zn₁₋ₓ₁Te, cadmium selenides-tellurides of the type CdTeₓSe₁₋ₓ, and alloys thereof,
and wherein the second material is a mercury-cadmium telluride of the type Cdₓ₂Hg₁₋ₓ₂Te.

5. The method for manufacturing a first support (100) according to any of claims 1 to 4, wherein during the step of forming an aperture (141), a remaining thickness D1 of the semiconductor layer (110) at the aperture (141) is between 0.1 and 2 µm, preferentially between 0.2 and 1 µm, or even 0.4 and 0.8 µm and can be, for example, substantially equal to 0.5 µm.

6. The manufacturing method according to any of the claims, wherein the step of implanting in a localised manner arsenic of the semiconductor layer (110) comprises the following sub-steps:
- first localised implantation of the semiconductor layer (110) on the first locations and the second location,
- second complementary implantation of the semiconductor layer (110) only on the second location (140).

7. The method for manufacturing a first support (100) according to any of claims 1 to 6, wherein during the step of removing the support layer (120) and a part of the thickness of the semiconductor layer (110), the selective etching is hydrocarbon plasma etching so as to provide an alignment mark projecting from the rest of the second surface of the semiconductor layer, the plasma used for etching being preferentially based on methane and dihydrogen.

8. The method for manufacturing a first support (100) according to any of claims 1 to 6, wherein during the step of removing the support layer (120) and a part of the thickness of the semiconductor layer (110), the etching is a wet chemical etching from an acidic solution comprising a chromium oxide so as to provide an alignment mark in the form of a valley relative to the rest of the second surface of the semiconductor layer.

9. The method for manufacturing an optoelectronic component (1) comprising the following steps:
- providing a first support (100) implementing a method for manufacturing a first support according to any of claims 1 to 8,
- providing a second support (200),
- assembling the first and the second support (100, 200), the second support (200) being aligned with the first support (100) by means of the alignment mark (140).

10. The method for manufacturing an optoelectronic component (1) according to claim 9, wherein it is further provided during the implementation of the method for manufacturing a first support (100), a step of forming on the first surface (110A) of the semiconductor layer (110), first metal contacts (132A, 132B, 132C) of each of the structures (130A, 130B, 130C),
the method for manufacturing an optoelectronic component (1) including, either as such or upon implementing the method for manufacturing a first support (100), the following steps:
- providing a third support (300) including an electronic control and processing circuit and second metal contacts corresponding to the first metal contacts,
- assembling the first and the third support (100, 300) by an operation of welding or soldering the first contacts to the second contacts, the assembling of the first and the third support (100, 300) being preferentially made by hybridisation through indium balls (310A, 310B, 310C).

11. The method for manufacturing an optoelectronic component (1) according to claim 9 or 10, wherein the second support includes a plurality of functional elements (210A, 210B, 210C), the elements of the second support being selected from optical elements including wavelength filters and optical concentration systems, and connection elements, such as connection tracks,
and wherein during assembling of the first ans second support (100, 200), the alignment of the second support (200) by the means of the alignment mark (140) allows to align each functional element (210A, 210B, 210C) with the corresponding structure (130A, 130B, 130C).

12. A first support (100) for forming, in particular with a second support (200), an optoelectronic component (1), the first support (100) having a first and a second face (100A, 100B, 100C) and comprising a semiconductor layer (110) forming said first support (100), the semiconductor layer (110) having a first and a second surface (110A, 110B) respectively forming the first and the second face (100A, 100B) of the first support (100), the semiconductor layer (110) being made of a second material which comprises a cadmium proportion x₂,
wherein the semiconductor layer (110) comprises:
- a plurality of diode type structures (130A, 130B, 130C) at least one metal contact of which flushes of the first surface (110A), the structures (130A, 130B, 130C) including doped zones (131A, 131B, 131C) each at a first respective location of the semiconductor layer (110), each doped zone (131A, 131B, 131C) having a second conductivity type in which the holes are the majority carriers, this second conductivity type being provided by means of an arsenic doping and an aperture (140) provided in the semiconductor layer (110) from the first surface (110A) towards the second surface (110B),
the first support (100) **being characterised in that** the semiconductor layer (110) further comprises:
- an alignment mark (140) formed at a second location (141) located in the aperture, the alignment mark (140) having the second conductivity type, the second conductivity type being provided by means of an arsenic doping opening into the second surface (110B), and an average cadmium proportion x₃ higher than the average cadmium proportion x₂ of the second material at the same distance from the second surface (110B), the alignment mark (140) flushing with the second surface (110B) of the semiconductor layer (110),
and **in that** the second surface (110B) of the semiconductor layer (110) has a height difference between the alignment mark (140), which flushes with the second surface (110B) and which corresponds to the second location (141), and the rest of the second surface (110B).

13. The first support according to claim 12, wherein the alignment mark (140) is in the form of a valley relative to the rest of the second surface (110B) of the semiconductor layer (110).

14. The first support according to claim 12, wherein the alignment mark (140) projects from the rest of the second surface (110B) of the semiconductor layer (110).

15. An optoelectronic component (1) comprising:
- a first support (100) according to any of claims 10 to 12,
- a second support (200),
wherein the first support (100) is assembled through its second face (100A) to the second support (200) by being aligned with the latter.
